# FASCICULE DE BREVET EUROPEEN

(11) **EP 3 295 473 B1**
(45) Date de publication et mention de la délivrance du brevet: **19.06.2019**
(21) Numéro de dépôt: 16726799.6
(22) Date de dépôt: 10.05.2016
(51) Int. Cl.: H01L 21/762, H01L 21/20

(54) **PROCEDE DE COLLAGE DIRECT DE SUBSTRATS AVEC AMINCISSEMENT DES BORDS D'AU MOINS UN DES DEUX SUBSTRATS**
VERFAHREN ZUR DIREKTEN VERBINDUNG VON SUBSTRATEN EINSCHLIESSLICH VERDÜNNUNG DER KANTEN VON MINDESTENS EINEM DER ZWEI SUBSTRATE
METHOD FOR DIRECT BONDING OF SUBSTRATES INCLUDING THINNING OF THE EDGES OF AT LEAST ONE OF THE TWO SUBSTRATES

(30) Priorité: 11.05.2015 FR 1554182
(43) Date de publication de la demande: 21.03.2018
(73) Titulaire: Commissariat à l'Energie Atomique et aux Energies Alternatives, 75015 Paris (FR)
(72) Inventeur: FOURNEL, Frank, 38190 Villard-Bonnot (FR); MORALES, Christophe, 38220 St Pierre De Mesage (FR); MORICEAU, Hubert, 38120 Saint-Egreve (FR); RIEUTORD, François, 38120 Saint-Egreve (FR)
(74) Mandataire: Brevalex
(86) Numéro de dépôt international: PCT/EP2016/060448
(87) Numéro de publication internationale: WO 2016/180828

(56) Documents cités:
- EP-A2- 0 451 993
- US-A1- 2004 121 557
- US-A1- 2007 072 393
- US-A1- 2007 148 914
- US-A1- 2010 087 046

## Description

### DOMAINE TECHNIQUE ET ART ANTÉRIEUR

L'invention concerne un procédé de collage direct de deux substrats entre eux au cours duquel un amincissement des bords d'au moins un des deux substrats est réalisé pour éviter l'apparition de défauts de collage au niveau des bords des substrats. On entend par substrat, une plaque ou une plaquette (également appelé « wafer » en anglais), par exemple en semi-conducteur (en général en silicium), ayant ou non déjà subie des étapes technologiques de la microélectronique formant par exemple des composants électroniques dans le substrat. Ces étapes technologiques de la microélectronique sont par exemple des étapes de lithographie, de gravure et de dépôt.

Le collage direct, également appelé « collage moléculaire », ou encore « wafer bonding » ou « direct bonding » en anglais, est une technique d'assemblage permettant de solidariser deux surfaces via une mise en contact direct de ces deux surfaces sans faire appel à un matériau de collage (colle, cire, etc.). Dans ce type de collage, l'adhérence est obtenue grâce au fait que les surfaces à coller sont suffisamment lisses (typiquement avec une rugosité de l'ordre de 0,5 nm), exemptes de particules ou de contaminations, et rapprochées suffisamment l'une de l'autre pour permettre d'initier un contact intime entre elles. Dans ce cas, les forces attractives entre les deux surfaces sont assez élevées pour provoquer une adhérence moléculaire des deux surfaces l'une avec l'autre. Le collage moléculaire est induit par l'ensemble des forces attractives d'interaction électronique entre les atomes ou molécules des deux matériaux à coller (forces de Van der Waals). Des traitements thermiques peuvent être réalisés pendant ou après le collage pour augmenter l'énergie de collage entre les surfaces assemblées.

Un tel collage direct peut correspondre à un collage dit « hydrophobe », par exemple entre deux substrats de silicium monocristallin sans oxyde de surface et avec des surfaces passivées par des liaisons Si-H par exemple. Dans ce cas, le collage direct forme un « raccord » cristallin entre les matériaux collés. Le collage direct peut également correspondre à un collage dit « hydrophile », par exemple entre deux substrats de silicium oxydé. Dans un tel collage hydrophile, les liaisons silanoles (Si-OH) de surfaces et un film d'eau présent entre les deux substrats permettent d'obtenir des interactions par liaisons hydrogène plus fortes que les forces de Van der Waals obtenues avec les surfaces passivées hydrogène avec les liaisons Si-H dans le cas du collage hydrophobe.

Après avoir mis en contact les deux substrats destinés à être collés l'un à l'autre, une légère pression mécanique est appliquée sur les substrats afin d'initier le collage direct. Cette pression permet d'amener les matériaux des deux substrats à une distance suffisamment faible pour que les forces d'attraction entre les atomes ou molécules des deux surfaces à coller puissent s'établir. Une onde de collage se propage alors à partir du point de pression, généralement au niveau des centres des substrats, sur toute l'étendue des surfaces, avec pour effet de coller intimement les deux substrats. Cette opération est généralement réaliser à température ambiante et à pression ambiante. Ainsi, cette onde de collage va, entre autre chose, évacuer l'air et une partie de l'eau présents entre les deux surfaces juste avant sa propagation. Cette évacuation engendre une surpression d'environ deux atmosphères au front de l'onde de collage.

Lorsque l'onde de collage arrive au niveau des bords des substrats, une détente adiabatique se produit et peut entraîner l'apparition de défauts au niveau des bords des substrats, et cela même si les surfaces de ces bords sont exactement identiques à celles au niveau des centres des substrats. De tels défauts peuvent également apparaître plus tardivement, par exemple lors de la mise en oeuvre de traitements thermiques réalisés pour augmenter l'énergie de collage entre les substrats.

Ces défauts de collage dus à la propagation de l'onde de collage apparaissent principalement lors de la mise en oeuvre d'un collage direct hydrophile car lors d'un tel collage, l'onde de collage se propage plus rapidement que lors d'un collage direct hydrophobe. La surpression est donc plus importante, tout comme la détente adiabatique, dans le cas d'un collage direct hydrophile. Toutefois, de tels défauts peuvent potentiellement apparaître lors d'un collage direct hydrophobe.

Pour résoudre ces problèmes, le document EP 2 115 768 propose de réaliser un chauffage des substrats au moins jusqu'à leur mise en contact l'un avec l'autre. De manière alternative, le document WO 2013/160841 propose de résoudre ces problèmes en réalisant le collage sous une atmosphère d'Hélium.

Les solutions proposées dans les documents cités ci-dessus nécessitent toutefois de modifier certaines propriétés de l'atmosphère (température, pression et nature des gaz en présence) dans laquelle le collage direct est réalisé. Or, cela est très contraignant car l'atmosphère des machines dans lesquelles le collage direct entre deux substrats est réalisé n'est généralement pas modifiable. De plus, la modification des conditions de mise en oeuvre du collage direct risque également de modifier les performances du collage réalisé.

Le document EP 0451993 décrit un procédé de collage de deux substrats dans lequel les bords du substrat supérieur ne sont pas supportés mécaniquement par le substrat inférieur lors de la solidarisation de ces deux substrats. Dans ce document, pour que les bords du premier substrat soient bien supportés par le deuxième substrat, le chanfrein du bord du premier substrat est réalisé du côté de la face destinée à être solidarisée au deuxième substrat.

### EXPOSÉ DE L'INVENTION

Un but de la présente invention est de proposer un procédé de collage direct entre au moins deux substrats permettant d'éviter l'apparition des défauts de collage dus à la propagation de l'onde de collage, et dans lequel une mise en contact des deux substrats peut être réalisée à température ambiante et à pression ambiante, par exemple sous l'atmosphère d'une salle blanche (comprenant de l'air à environ 50 % d'humidité relative à 21°C).

Pour cela, l'invention propose un procédé de collage direct entre au moins un premier et un deuxième substrats, chacun des premier et deuxième substrats comportant une première et une deuxième faces principales, comportant au moins les étapes de :
- premier amincissement de bords du premier substrat sur au moins une partie de la circonférence du premier substrat, au niveau de la première face principale du premier substrat ;
- mise en contact de la deuxième face principale du premier substrat avec la deuxième face principale du deuxième substrat telle qu'une onde de collage se propage entre les premier et deuxième substrats, solidarisant les premier et deuxième substrats l'un à l'autre par collage direct.

La solidarisation des premier et deuxième substrats l'un à l'autre peut être telle que des parties de la deuxième face principale du premier substrat se trouvant sous, ou à l'aplomb, des parties amincies de la première face principale du premier substrat sont solidarisées au deuxième substrat.

Le procédé selon l'invention propose de réaliser, préalablement à la mise en contact des substrats à solidariser, un amincissement des bords du premier substrat sur au moins une partie de la circonférence du premier substrat. Le fait que les bords du premier substrat soient amincis permet de rendre moins rigide le premier substrat au niveau de ces bords. Ainsi, après la mise en contact des deux substrats, lorsque l'onde de collage arrive au niveau de ces bords, le premier substrat a la capacité de se déformer légèrement afin d'éviter la formation de défauts dus à la détente adiabatique se produisant lors du passage de l'onde de collage au niveau des bords des substrats.

Le bord aminci obtenu par la mise en oeuvre du premier amincissement est différent d'un chanfrein classique réalisé au niveau des bords d'un substrat. En effet, un chanfrein classique n'apporte aucune souplesse aux substrats lors de la solidarisation des substrats l'un à l'autre car les parties des substrats comportant les chanfreins ne sont pas destinées à être collées l'une à l'autre. Dans l'invention, la souplesse est apportée grâce au premier amincissement qui est réalisé sur une plus grande partie des bords que celle au niveau de laquelle les chanfreins sont réalisés, ce qui se traduit par le fait qu'à l'issue du collage, les parties de la deuxième face principale du premier substrat se trouvant sous les parties amincies de la première face principale du premier substrat sont solidarisées au deuxième substrat. La souplesse est ainsi obtenue du fait que l'amincissement est réalisé sur des parties du premier substrat qui sont destinées à être collées au deuxième substrat.

Lorsque l'onde de collage est initiée depuis un point d'initiation localisé au niveau des bords des premier et deuxième substrats, ladite au moins une partie de la circonférence du premier substrat peut correspondre à au moins un tiers de la circonférence du premier substrat et peut être localisée à l'opposé du point d'initiation.

L'onde de collage peut être initiée en appliquant une pression mécanique sur au moins l'un des deux substrats.

De manière avantageuse, le premier amincissement peut être réalisé sur l'ensemble de la circonférence du premier substrat. Cette configuration est avantageusement réalisée lorsque le point d'initiation de l'onde de collage est localisé sensiblement au niveau des centres des substrats.

Le premier amincissement peut être réalisé tel qu'une différence entre une épaisseur minimale des bords amincis du premier substrat et une épaisseur de bords du deuxième substrat soit supérieure ou égale à 20 % et qu'une valeur minimale parmi l'épaisseur minimale des bords amincis du premier substrat et l'épaisseur des bords du deuxième substrat soit inférieure ou égale à 580 µm. Ainsi, outre le fait que les bords les plus minces parmi les bords amincis du premier substrat et les bords du deuxième substrat ont une épaisseur inférieure ou égale à 580 µm, l'épaisseur minimale des bords amincis du premier substrat peut être inférieure ou égale à environ 80 % de l'épaisseur des bords du deuxième substrat, ou l'épaisseur des bords du deuxième substrat peut être inférieure ou égale à environ 80% de l'épaisseur minimale des bords amincis du premier substrat.

Le premier amincissement peut être réalisé tel qu'une différence entre une épaisseur minimale des bords amincis du premier substrat et une épaisseur des autres parties du premier substrat soit supérieure ou égale à environ 20 %.

Le premier amincissement peut être réalisé tel qu'une largeur des bords amincis du premier substrat soit comprise entre environ 1% et 25% du diamètre du premier substrat. La largeur correspond à la dimension parallèle au diamètre du premier substrat.

Le premier amincissement peut être réalisé tel que l'épaisseur des bords amincis du premier substrat soit sensiblement constante, ou tel que l'épaisseur des bords amincis diminue sur au moins une partie de la largeur des bords amincis, ou tel que l'épaisseur des bords amincis varie selon un profil comportant au moins deux pentes.

Le procédé peut comporter en outre, avant la mise en contact de la deuxième face principale du premier substrat avec la deuxième face principale du deuxième substrat, la mise en oeuvre d'un deuxième amincissement d'au moins une partie de bords du deuxième substrat, au niveau de la première face principale du deuxième substrat.

Le collage direct solidarisant les premier et deuxième substrats l'un à l'autre peut correspondre à un collage direct hydrophile.

Les premier et deuxième substrats peuvent comporter chacun un semi-conducteur, et le procédé peut comporter en outre, avant la mise en contact de la deuxième face principale du premier substrat avec la deuxième face principale du deuxième substrat, la mise en oeuvre d'une oxydation d'au moins la deuxième face principale d'au moins l'un des premier et deuxième substrats.

Le procédé peut comporter en outre, entre le premier amincissement et la mise en contact de la deuxième face principale du premier substrat avec la deuxième face principale du deuxième substrat, la mise en oeuvre d'un polissage d'une extrémité des bords amincis du premier substrat.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 et 2 représentent les étapes d'un procédé de collage direct entre deux substrats, objet de la présente invention, selon un mode de réalisation particulier ;
- les figures 3 et 4 représentent des variantes de réalisation d'un amincissement des bords d'un substrat mis en oeuvre lors d'un procédé de collage direct entre deux substrats, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

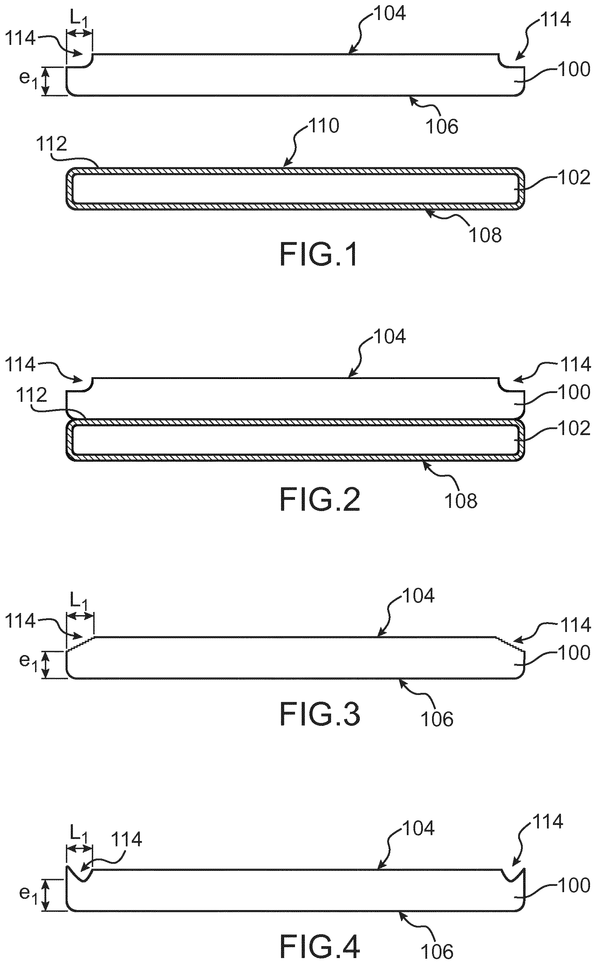

On se réfère tout d'abord aux figures 1 et 2 qui représentent les étapes d'un procédé de collage direct entre un premier substrat 100 et un deuxième substrat 102 selon un mode de réalisation particulier.

Chacun des deux substrats 100 et 102 correspond ici à un substrat de silicium d'orientation cristalline <001>, de diamètre égal à 200 mm, d'épaisseur égale à 725 µm, et de dopage P avec une résistivité comprise entre environ 1 Ohm/cm et 10 Ohm/cm. Le premier substrat 100 comporte une première face principale 104 et une deuxième face principale 106. Le deuxième substrat 102 comporte une première face principale 108 et une deuxième face principale 110.

Une oxydation thermique du deuxième substrat 102 est mise en oeuvre afin de former autour de celui-ci une couche d'oxyde thermique 112, ici à base de SiO₂ du fait que le deuxième substrat 102 est un substrat de silicium. Cette oxydation thermique est par exemple réalisée à une température égale à environ 950°C sous atmosphère d'oxygène. La couche d'oxyde thermique 112 a par exemple une épaisseur égale à environ 50 nm.

Un amincissement des bords 114 du premier substrat 100 est ensuite réalisé, par exemple par rodage, et tel que l'épaisseur e₁ des bords 114 après amincissement soit inférieure ou égale à 80 % de l'épaisseur initiale du premier substrat 100, c'est-à-dire inférieure ou égale à 580 µm dans le cas d'un premier substrat 100 d'épaisseur égale à 725 µm. Dans l'exemple de réalisation décrit ici, l'épaisseur e₁ des bords 114 amincis est égale à environ 500 µm. Cet amincissement des bords 114 du premier substrat 100 est réalisé au niveau de la première face principale 104 du premier substrat 100. De plus, cet amincissement est réalisé tel qu'une largeur L₁ des bords 114 amincis soit comprise entre environ 1% et 25% du diamètre du premier substrat 100. Dans l'exemple de réalisation décrit ici, la largeur L₁ est égale à environ 10 mm. L'épaisseur e₁ des bords 114 amincis est sensiblement constante sur toute cette largeur L₁.

Cet amincissement est réalisé sur une partie plus importante des bords du premier substrat 100 que celle au niveau de laquelle se trouvent les chanfreins classique d'un substrat.

Cet amincissement forme ici, au niveau des bords 114 de la première face principale 104 du premier substrat 100, une « marche » de hauteur égale à environ 225 µm. La figure 1 représente les substrats 100 et 102 ainsi obtenus.

Dans l'exemple de réalisation décrit ici, l'amincissement des bords 114 est réalisé sur l'ensemble de la circonférence du premier substrat 100. En variante, notamment lorsque l'onde de collage est destinée à être initiée depuis un point d'initiation localisé au niveau des bords des premier et deuxième substrats 100, 102, il est possible que cet amincissement soit réalisé sur une partie seulement de la circonférence du premier substrat 100, cette partie correspondant à au moins un tiers de la circonférence du premier substrat 100 et étant localisée à l'opposé du point d'initiation de l'onde de collage qui sera obtenue plus loin.

Les premier et deuxième substrats 100, 102 sont ensuite nettoyés avec une solution à base d'acide sulfurique et d'eau oxygénée (avec environ 3 fois plus d'acide sulfurique que d'eau oxygénée dans la solution), également appelée SPM (« Sulfuric Peroxide Mixture »), pendant une durée égale à environ 10 minutes, puis rincés à l'eau déionisée pendant environ 10 minutes, et plongés dans une solution à base d'ammoniaque, d'eau oxygénée et d'eau dé-ionisée (avec respectivement des proportions 1 / 1 / 5 dans la solution), également appelée APM (« Ammonium Peroxide Mixture »), pendant environ 10 minutes et à une température d'environ 70°C. Un dernier rinçage à l'eau déionisée est réalisé.

Les faces 106 et 110 ont une rugosité compatible avec la mise en oeuvre d'un collage direct, c'est-à-dire ont une rugosité inférieure ou égale à environ 0,5 nm. Si le premier substrat 100 et/ou le deuxième substrat 102 n'ont pas une rugosité de surface compatible avec la mise en oeuvre d'un collage direct, des étapes de planarisation peuvent être mises en oeuvre au préalable afin de rendre les surfaces compatibles avec la mise en oeuvre d'un collage direct.

Comme représenté sur la figure 2, une mise en contact de la deuxième face principale 106 du premier substrat 100 avec la deuxième face principale 110 (formée ici d'oxyde de semi-conducteur) du deuxième substrat 102 est ensuite réalisée. Lors de cette mise en contact, le deuxième substrat 102 est disposé sur un support et le premier substrat 100 est ensuite déposé sur le deuxième substrat 102. Une pression peut être appliquée au niveau du centre de la première face principale 104 du premier substrat 100 afin de déclencher la propagation de l'onde de collage depuis les centres des substrats 100, 102 jusqu'au niveau des bords des substrats 100, 102. Le fait que les bords 114 du premier substrat 100 soient amincis permet de rendre moins rigide le premier substrat 100 au niveau de ces bords 100. Ainsi, lorsque l'onde de collage arrive au niveau de ces bords, le premier substrat 100 peut se déformer légèrement afin d'éviter la formation de défauts dus à la détente adiabatique se produisant lors du passage de l'onde de collage au niveau des bords des substrats 100, 102. Cette étape de mise en contact des deux substrats 100, 102 est réalisée à température ambiante et à pression ambiante par exemple en salle blanche avec un air à environ 21°C et environ 50% d'humidité relative.

A l'issue de cette mise en contact, les parties de la deuxième face principale 106 se trouvant sous les parties amincies de la première face principale 104, c'est-à-dire les parties de la deuxième face principale 106 se trouvant à l'aplomb des parties amincies de la première face principale 104, sont solidarisées au deuxième substrat 102.

L'énergie de collage est ensuite renforcée en réalisant un recuit des deux substrats solidarisés 100, 102, par exemple à une température de 400°C pendant 2 heures. De manière générale, un ou plusieurs traitements thermiques permettant un renforcement des forces d'adhésion entre les substrats 100 et 102 peuvent être réalisés. Lorsque des composants électroniques sont présents sur au moins l'un de ces substrats 100, 102 (au niveau des premières faces 104, 108), les températures de ces traitements thermiques peuvent être comprises entre environ 200°C et 400°C. Dans le cas contraire, les températures de traitements thermiques peuvent aller jusqu'à environ 1100°C.

Préalablement à la mise en contact des substrats 100 et 102, il est possible de réaliser un polissage de l'extrémité des bords 114 amincis du premier substrat 100 afin « d'arrondir » le profil des bords 114 amincis. Ce polissage peut être réalisé par attaque chimique. Un tel polissage permet également d'éliminer les éventuelles zones écrouies qui pourraient être source de fragilité pour le collage.

Dans le mode de réalisation particulier décrit ci-dessus, l'épaisseur e₁ des bords 114 amincis est inférieure ou égale à 80 % de l'épaisseur initiale du deuxième substrat 102, les épaisseurs initiales des premier et deuxième substrats 100, 102 étant ici sensiblement égales l'une par rapport à l'autre et inférieures ou égales à environ 725 µm. Lorsque les épaisseurs initiales des premier et deuxième substrats 100, 102 sont supérieures à environ 725 µm, l'amincissement des bords 114 du premier substrat 100 est réalisé tel que l'épaisseur des bords 114 amincis du premier substrat 100 soit inférieure ou égale à environ 580 µm.

L'amincissement est réalisé tel que les bords d'au moins l'un des deux substrats 100, 102 aient une épaisseur inférieure ou égale à environ 580 µm, et qu'une différence entre les épaisseurs des bords des deux substrats soit d'au moins 20 % l'une par rapport à l'autre.

Dans le mode de réalisation particulier précédemment décrit, l'amincissement des bords 114 du premier substrat 100 est réalisé tel que l'épaisseur e₁ des bords 114 amincis du premier substrat 100 soit sensiblement constante sur toute la largeur Li sur laquelle cet amincissement est réalisé. En variante, cet amincissement des bords 114 du premier substrat 100 peut être réalisé tel que la variation d'épaisseur créée par cet amincissement soit moins abrupte. Par exemple, l'amincissement peut être réalisé tel que l'épaisseur des bords 114 amincis diminue sur au moins une partie de la largeur Li des bords 114 amincis. Des bords 114 ainsi amincis sont représentés par exemple sur la figure 3. Pour réaliser de tels bords 114, une scie de découpe est utilisée pour réaliser des traits de scie au niveau de la première face 104 du premier substrat 100. Du fait que la profondeur des traits de scie formés dans le substrat 100 peut être contrôlée, il est possible de réaliser les bords 114 amincis avec différents profils, selon la configuration souhaitée. Une telle scie peut par exemple former un trait de largeur égale à environ 1 mm. Sur l'exemple de la figure 3, 10 traits sont réalisés successivement tels que les bords amincis aient une largeur Li égale à environ 10 mm. Chaque trait est réalisé sur une profondeur égale à 22,5 µm par rapport au trait précédent afin que l'épaisseur minimale e₁ des bords 114 amincis, au niveau de leur extrémité, soit égale à environ 500 µm (725 µm - 10 x 22,5 µm).

Selon une autre variante, l'amincissement peut être réalisé tel que l'épaisseur des bords 114 amincis varie selon un profil comportant au moins deux pentes. Sur l'exemple de la figure 4, l'épaisseur des bords 114 amincis varie selon un profil comportant deux pentes, formant un profil en « V ». Un tel profil est par exemple réalisé en réalisant 10 traits de scie successivement tels que les bords amincis aient une largeur L₁ égale à environ 10 mm. Chaque trait est réalisé sur une profondeur égale à 45 µm par rapport au trait précédent afin que l'épaisseur minimale des bords 114 amincis, au niveau du milieu des bords amincis, soit égale à environ 500 µm (725 µm - 5 x 45 µm).

D'autres formes ou profils d'amincissement des bords 114 peuvent être envisagés. De plus, des outils de rodage différents d'une scie de découpe peuvent être utilisés pour réaliser l'amincissement des bords 114 du premier substrat 100.

En variante, il est également possible de réaliser, avant la mise en contact des deux substrats 100, 102, un deuxième amincissement des bords du deuxième substrat 102, au niveau de la première face principale 108 du deuxième substrat 102. Les différentes variantes précédemment décrites pour l'amincissement des bords du premier substrat 100 peuvent s'appliquer pour ce deuxième amincissement. Ce deuxième amincissement peut être réalisé tel que les bords amincis d'au moins l'un des deux substrats aient une épaisseur inférieure ou égale à environ 580 µm ou 544 µm, et qu'une différence entre les épaisseurs des bords amincis des deux substrats soit d'au moins 20 % ou 25 % l'une par rapport à l'autre.

En variante, il est également possible de réaliser, avant la mise en contact des deux substrats 100, 102, une oxydation du premier substrat 100, en remplacement ou en complément de l'oxydation du deuxième substrat 102.

Dans les exemples précédemment décrits, le collage direct réalisé correspond à un collage de type hydrophile en raison de la nature hydrophile des matériaux solidarisés. En variante, l'amincissement des bords d'un ou des substrats solidarisés peut également être réalisé dans le cas d'un collage direct de type hydrophobe.

Ce procédé de collage direct s'applique avantageusement à l'élaboration d'un substrat SOI, ou le transfert de circuits pour la fabrication d'imageur retro-éclairé, ou encore pour les applications 3D.

## Revendications

1. Procédé de collage direct entre au moins un premier et un deuxième substrats (100, 102), chacun des premier et deuxième substrats (100, 102) comportant une première et une deuxième faces principales (104, 106, 108, 110), comportant au moins les étapes de :
- premier amincissement de bords (114) du premier substrat (100) sur au moins une partie de la circonférence du premier substrat (100), au niveau de la première face principale (104) du premier substrat (100) ;
- mise en contact de la deuxième face principale (106) du premier substrat (100) avec la deuxième face principale (110) du deuxième substrat (102) telle qu'une onde de collage se propage entre les premier et deuxième substrats (100, 102), solidarisant les premier et deuxième substrats (100, 102) l'un à l'autre par collage direct tel que des parties de la deuxième face principale (106) du premier substrat (100) se trouvant sous des parties amincies de la première face principale (104) du premier substrat (100) sont solidarisées au deuxième substrat (102)
et dans lequel le premier amincissement est réalisé tel qu'une différence entre une épaisseur minimale des bords (114) amincis du premier substrat (100) et une épaisseur de bords du deuxième substrat (102) soit supérieure ou égale à 20 %, et qu'une valeur minimale parmi l'épaisseur minimale des bords (114) amincis du premier substrat (100) et l'épaisseur des bords du deuxième substrat (102) soit inférieure ou égale à 580 µm.

2. Procédé selon la revendication 1, dans lequel, lorsque l'onde de collage est initiée depuis un point d'initiation localisé au niveau des bords des premier et deuxième substrats (100, 102), ladite au moins une partie de la circonférence du premier substrat (100) correspond à au moins un tiers de la circonférence du premier substrat (100) et est localisée à l'opposé du point d'initiation.

3. Procédé selon l'une des revendications précédentes, dans lequel le premier amincissement est réalisé sur l'ensemble de la circonférence du premier substrat (100).

4. Procédé selon l'une des revendications précédentes, dans lequel le premier amincissement est réalisé tel qu'une largeur des bords (114) amincis du premier substrat (100) soit comprise entre 1% et 25% du diamètre du premier substrat (100).

5. Procédé selon l'une des revendications précédentes, dans lequel le premier amincissement est réalisé tel que l'épaisseur des bords (114) amincis du premier substrat (100) soit sensiblement constante, ou tel que l'épaisseur des bords (114) amincis diminue sur au moins une partie de la largeur des bords (114) amincis, ou tel que l'épaisseur des bords (114) amincis varie selon un profil comportant au moins deux pentes.

6. Procédé selon l'une des revendications précédentes, comportant en outre, avant la mise en contact de la deuxième face principale (106) du premier substrat (100) avec la deuxième face principale (110) du deuxième substrat (102), la mise en oeuvre d'un deuxième amincissement d'au moins une partie de bords du deuxième substrat (102), au niveau de la première face principale (108) du deuxième substrat (102).

7. Procédé selon l'une des revendications précédentes, dans lequel le collage direct solidarisant les premier et deuxième substrats (100, 102) l'un à l'autre correspond à un collage direct hydrophile.

8. Procédé selon l'une des revendications précédentes, dans lequel les premier et deuxième substrats (100, 102) comportent chacun un semi-conducteur, et comportant en outre, avant la mise en contact de la deuxième face principale (106) du premier substrat (100) avec la deuxième face principale (110) du deuxième substrat (102), la mise en oeuvre d'une oxydation d'au moins la deuxième face principale (106, 110) d'au moins l'un des premier et deuxième substrats (100, 102).

9. Procédé selon l'une des revendications précédentes, comportant en outre, entre le premier amincissement et la mise en contact de la deuxième face principale (106) du premier substrat (100) avec la deuxième face principale (110) du deuxième substrat (102), la mise en oeuvre d'un polissage d'une extrémité des bords (114) amincis du premier substrat (100).

## Patentansprüche

1. Verfahren zur direkten Verbindung wenigstens eines ersten und eines zweiten Substrats (100, 102), wobei jedes von erstem und zweiten Substrat (100, 102) eine erste und eine zweite Hauptseite (104, 106, 108, 110) aufweist, umfassend wenigstens die folgenden Schritte:
- erste Verdünnung der Kanten (114) des ersten Substrats (100) an wenigstens einem Teil des Umfangs des ersten Substrats (100) an der ersten Hauptseite (104) des ersten Substrats (100);
- Inkontaktbringen der zweiten Hauptseite (106) des ersten Substrats (100) mit der zweiten Hauptseite (110) des zweiten Substrats (102) derart, dass sich eine Verbindungswelle zwischen dem ersten und zweiten Substrat (100, 102) ausbreitet, welche das erste und das zweite Substrat (100, 102) durch direkte Verbindung derart zusammenhält, dass Teile der zweiten Hauptseite (106) des ersten Substrats (100), die sich unter den verdünnten Teilen der ersten Hauptseite (104) des ersten Substrats (100) befinden, mit dem zweiten Substrat (102) verbunden werden und wobei die erste Verdünnung derart ausgeführt wird, dass ein Unterschied zwischen einer minimalen Dicke der verdünnten Kanten (114) des ersten Substrats (100) und einer Dicke der Kanten des zweiten Substrats (102) größer gleich 20% ist und so, dass ein minimaler Wert aus minimaler Dicke der verdünnten Kanten (114) des ersten Substrats (100) und Dicke der Kanten des zweiten Substrats (102) kleiner gleich 580 µm ist.

2. Verfahren nach Anspruch 1, bei welchem, wenn die Verbindungswelle von einem Initialisierungspunkt, der sich an den Kanten des ersten und des zweiten Substrats (100, 102) befindet, aus initialisiert wird, der wenigstens eine Teil des Umfangs des ersten Substrats (100) wenigstens einem Drittel des Umfangs des ersten Substrats (100) entspricht und gegenüber dem Initialisierungspunkt angeordnet ist.

3. Verfahren nach einem der vorhergehenden Ansprüche, bei welchem die erste Verdünnung an dem gesamten Umfang des ersten Substrats (100) ausgeführt wird.

4. Verfahren nach einem der vorhergehenden Ansprüche, bei welchem die erste Verdünnung derart ausgeführt wird, dass eine Breite der verdünnten Kanten (114) des ersten Substrats (100) 1-25% des Durchmessers des ersten Substrats (100) beträgt.

5. Verfahren nach einem der vorhergehenden Ansprüche, bei welchem die erste Verdünnung derart ausgeführt wird, dass die Dicke der verdünnten Kanten (114) des ersten Substrats (100) im Wesentlichen konstant ist, oder so, dass die Dicke der verdünnten Kanten (114) über wenigstens einen Teil der Breite der verdünnten Kanten (114) abnimmt, oder so, dass die Dicke der verdünnten Kanten (114) gemäß einem Profil variiert, das wenigstens zwei Schrägen aufweist.

6. Verfahren nach einem der vorhergehenden Ansprüche, welches ferner vor dem Inkontaktbringen der zweiten Hauptseite (106) des ersten Substrats (100) mit der zweiten Hauptseite (110) des zweiten Substrats (102) die Realisierung einer zweiten Verdünnung wenigstens eines Teils der Kanten des zweiten Substrats (102) an der ersten Hauptseite (108) des zweiten Substrats (102) umfasst.

7. Verfahren nach einem der vorhergehenden Ansprüche, bei welchem die direkte Verbindung zum Zusammenhalt des ersten und des zweiten Substrats (100, 102) aneinander einer direkten hydrophilen Verbindung entspricht.

8. Verfahren nach einem der vorhergehenden Ansprüche, bei welchem das erste und das zweite Substrat (100, 102) jeweils einen Halbleiter umfassen und ferner vor dem Inkontaktbringen der zweiten Hauptseite (106) des ersten Substrats (100) mit der zweiten Hauptseite (110) des zweiten Substrats (102) die Realisierung einer Oxidation wenigstens der zweiten Hauptseite (106, 110) wenigstens eines aus erstem und zweitem Substrat (100, 102) umfassen.

9. Verfahren nach einem der vorhergehenden Ansprüche, welches ferner zwischen der ersten Verdünnung und dem Inkontaktbringen der zweiten Hauptseite (106) des ersten Substrats (100) mit der zweiten Hauptseite (110) des zweiten Substrats (102) das Realisieren eines Polierens eines Endes der verdünnten Kanten (114) des ersten Substrats (100) umfasst.

## Claims

1. A method of direct bonding between at least a first and a second substrates (100, 102), each of the first and second substrates (100, 102) including a first and a second main faces (104, 106, 108, 110), including at least the steps of:
- first thinning edges (114) of the first substrate (100) on at least one part of the circumference of the first substrate (100), at the first main face (104) of the first substrate (100);
- contacting the second main face (106) of the first substrate (100) with the second main face (110) of the second substrate (102) such that a bonding wave propagates between the first and second substrates (100, 102), securing the first and second substrates (100, 102) to each other by direct bonding such that parts of the second main face (106) of the first substrate (100) located under thinned parts of the first main face (104) of the first substrate (100) are secured to the second substrate (102)
and wherein the first thinning is carried out such that a difference between a minimum thickness of the thinned edges (114) of the first substrate (100) and a thickness of edges of the second substrate (102) is higher than or equal to 20 %, and that a minimum value among the minimum thickness of the thinned edges (114) of the first substrate (100) and the thickness of the edges of the second substrate (102) is lower than or equal to 580 µm.

2. The method according to claim 1, wherein, when the bonding wave is initiated from an initiating point located at the edges of the first and second substrates (100, 102), said at least one part of the circumference of the first substrate (100) corresponds to at least one third of the circumference of the first substrate (100) and is located opposite to the initiating point.

3. The method according to one of the preceding claims, wherein the first thinning is carried out on the entire circumference of the first substrate (100).

4. The method according to one of the preceding claims, wherein the first thinning is carried out such that a width of the thinned edges (114) of the first substrate (100) is between 1 % and 25 % of the diameter of the first substrate (100).

5. The method according to one of the preceding claims, wherein the first thinning is carried out such that the thickness of the thinned edges (114) of the first substrate (100) is substantially constant, or such that the thickness of the thinned edges (114) decreases over at least one part of the width of the thinned edges (114), or such that the thickness of the thinned edges (114) varies according to a profile including at least two slopes.

6. The method according to one of the preceding claims, further including, before contacting the second main face (106) of the first substrate (100) with the second main face (110) of the second substrate (102), implementing a second thinning of at least one part of edges of the second substrate (102), at the first main face (108) of the second substrate (102).

7. The method according to one of the preceding claims, wherein the direct bonding securing the first and second substrates (100, 102) to each other corresponds to a hydrophilic direct bonding.

8. The method according to one of the preceding claims, wherein the first and second substrates (100, 102) each include a semiconductor, and further including, before contacting the second main face (106) of the first substrate (100) with the second main face (110) of the second substrate (102), implementing an oxidation of at least the second main face (106, 110) of at least one of the first and second substrates (100, 102).

9. The method according to one of the preceding claims, further including, between the first thinning and the contacting of the second main face (106) of the first substrate (100) with the second main face (110) of the second substrate (102), implementing a polishing of one end of the thinned edges (114) of the first substrate (100).
